# EUROPÄISCHE PATENTSCHRIFT

(11) **EP 1 164 380 B1**
(45) Veröffentlichungstag und Bekanntmachung des Hinweises auf die Patenterteilung: **07.09.2005**
(21) Anmeldenummer: 01112530.9
(22) Anmeldetag: 23.05.2001
(51) Int. Cl.: G01R 27/26

(54) **Schaltungsanordnung zur Erfassung von Kapazitätsänderungen**
Circuit for detecting changes in capacitance
Circuit pout détecter des changements de capacitance

(30) Priorität: 06.06.2000 DE 10027507
(43) Veröffentlichungstag der Anmeldung: 19.12.2001
(73) Patentinhaber: Rechner Industrie-Elektronik GmbH, 68623 Lampertheim (DE)
(72) Erfinder: Kohler, Armin, Dr., 68623 Lampertheim (DE); Pok, Ulrich, Dipl.-Ing., 06120 Halle (DE)
(74) Vertreter: Zinngrebe, Horst

(56) Entgegenhaltungen:
- DE-A- 19 843 749
- DE-C- 630 895
- US-A- 1 369 403
- US-A- 2 498 103
- US-A- 4 093 915

## Beschreibung

Die Erfindung betrifft eine Schaltungsanordnung zum Erfassen von Kapazitätsänderungen eines Kondensators, bei der in einem ersten Brückenzweig einer mit einer Wechselspannung beaufschlagten Brückenschaltung der Kondensator und in einem elektrisch parallelen zweiten Brückenzweig ein Referenzwiderstand vorgesehen sind.

Die US 1 369 403 A betrifft gemäß Figur 2 eine Schaltung zum Messen der Kapazität eines Leiters. Ein erster Brückenzweig umfasst einen Kondensator sowie einen einstellbaren Widerstand und ein zweiter Brückenzweig einen Kondensator mit gleichem Wert wie der Kondensator des ersten Brückenzweiges. Zwischen den Brückenzweigen sind Verstärker und Gleichrichter angeordnet, die mit den Eingängen eines Galvanometers verbunden sind. Wird der Leiter mit zu messender Kapazität nach Abgleich der Schaltung mit dem ersten Brückenzweig und parallel zum entsprechenden Kondensator verbunden, erfährt die ursprünglich abgeglichene Schaltung ein Ungleichgewicht, welches das Galvanometer durch Ausschlag anzeigt. Insbesondere, wenn die Schaltung nicht zuvor abgeglichen wurde, wird die Kapazität des Leiters durch anschließenden Abgleich mittels des einstellbaren Widerstands ermittelt.

In dem Dokument DE 198 43 749 A1 ist ein Verfahren und eine Schaltungsanordnung zur Auswertung kleiner Kapazitätsänderungen beschrieben, bei eine mit einer Wechselspannung beaufschlagte Brückenschaltung verwendet wird. Im ersten Brückenzweig liegt eine Reihenschaltung aus einem festen und einem veränderlichen Kondensator, im zweiten Brückenzweig ist eine Reihenschaltung aus zwei festen Kondensatoren vorgesehen. Von beiden Zweigen werden je eine Teilspannung abgegriffen und für eine Auswertung bereit gestellt.

Demgegenüber liegt der Erfindung die Aufgabe zugrunde, die eingangs genannte Erfassung von Kapazitätsänderungen mit einfacheren Mitteln zu realisieren.

Bei einer Schaltungsanordnung zum Erfassen von Kapazitätsänderungen eines Kondensators, bei der in einem ersten Brückenzweig einer mit einer Wechselspannung beaufschlagten Brückenschaltung der Kondensator und in einem elektrisch parallelen, zweiten Brückenzweig ein Referenzwiderstand vorgesehen sind, zeichnet sich die Erfindung dadurch aus, dass in dem ersten Brückenzweig dem Kondensator ein Messkanal und in dem zweiten Brückenzweig dem Referenzwiderstand ein Vergleichskanal nachgeschaltet sind, wobei die beiden Brückenzweige für das Ausgangssignal eines Wechselspannungsgenerators gleiche Übertragungseigenschaften haben, das verstärkte und gleichgerichtete Referenzwiderstands-Ausgangssignal, d.h. das auf einer Ausgangsleitung des Vergleichskanals auftretende Signal, von dem verstärkten und gleichgerichteten Kondensator-Ausgangssignal, d.h. von dem auf einer Ausgangsleitung des Messkanals auftretenden Signal, subtrahiert und das sich aus der Subtraktion ergebende Änderungssignal einer Anzeigeschaltung zugeführt wird. Ein Regelkreis weist einen Regelverstärker auf, der an einem Eingang das verstärkte und gleichgerichtete, auf der Ausgangsleitung des Vergleichskanals auftretende Signal als Ist-Signal und an einem zweiten Eingang ein Signal eines Spannungsnormals als Soll-Signal aufnimmt und an seinem Ausgang ein Stellsignal für den Generator liefert.

Da nach der Erfindung das Änderungssignal von der Grundkapazität des Kondensators unabhängig ist, ermöglicht sie die Erfassung des absoluten Wertes der Kapazitätsänderung. Liegt daher die Kapazitätsänderung wegen ihrer Kleinheit sehr nahe an der durch die Anzeigeschaltung vorgegebenen Erfassbarkeitsgrenze, braucht nach der Erfindung bei sonst gleichen äußeren Verhältnissen nur die Grundkapazität des Kondensators so erhöht werden, dass die entsprechend erhöhte Kapazitätsänderung im sicheren Erfassbarkeitsbereich liegt. Auf diese Weise lassen sich selbst kleinste auf bestimmte Meßvolumen bezogene Kapazitätsänderungen zuverlässig feststellen.

Wenn in bevorzugter Ausführungsform der Erfindung der Referenzwiderstand ein rein Ohm'scher Widerstand ist, sind außer dem Kondensator mit veränderlicher Kapazität keine weiteren Kondensatoren, deren Kapazität üblicherweise einen erheblichen Temperaturgang aufweist, erforderlich.

Die Verstärkung und Gleichrichtung des Referenzwiderstands-Ausgangssignals kann zweckmäßig in einem üblichen Wechselspannungsverstärker mit nachfolgender Gleichrichtung geschehen. Ein elektrisch möglichst gleichartiger Wechselspannungsverstärker mit nachgeschalteter Gleichrichtung kann zur Verstärkung und Gleichrichtung des Kondensators-Ausgangssignals vorgesehen sein. Um eine mögliche temperaturbedingte Drift beider Wechselspannungsverstärker möglichst gleich zu machen, sieht eine Weiterbildung der Erfindung vor, dass beide Wechselspannungsverstärker mit Gleichrichtern in inniger körperlicher Verbindung beispielsweise als integrierter Schaltkreis angeordnet sind.

In weiterer Ausführungsform der Erfindung kann die Differenzbildung durch Invertieren des Referenzwiderstands-Ausgangssignals und Zuführen des invertierten Referenzwiderstands-Ausgangssignals sowie des verstärkten und gleichgerichteten Kondensator-Ausgangssignals zu je einem Eingang eines Summierers realisiert sein.

Erfindungsgemäß soll das Änderungssignal den Wert Null haben, wenn die Kapazitätsänderung des Kondensators ebenfalls Null ist. Für diese Situation empfiehlt sich ein Abgleich für das verstärkte, gleichgerichtete und gegebenenfalls invertierte Referenzwiderstands-Ausgangssignal an das verstärkte und gleichgerichtete Kondensator-Ausgangssignal in der Weise, dass das verstärkte und gleichgerichtete sowie gegebenenfalls invertierte Referenzwiderstands-Ausgangssignal über einen zweckmäßig ohmschen Spannungsteiler mit verstellbarem Abgriff dem Differenz- oder Summenbildner zugeführt wird.

Wenn in Durchführung der Erfindung zur sicheren Erfaßbarkeit des Änderungssignals die Kapazität des Kondensators erhöht werden muß, empfiehlt es sich, den Referenzwiderstand veränderbar auszubilden, so daß bei Übergang zu einem Kondensator anderer Kapazität ein entsprechend anderer Referenzwiderstand benutzt wird.

Die Genauigkeit der Erfassung der Kapazitätsänderung wird verbessert, wenn das Ausgangssignal des Wechselspannungsgenerators stabilisiert ist, eine Temperaturdrift also nicht auftritt. Dies läßt sich nach einer Weiterbildung der Erfindung durch den zusätzlichen Regelkreis erreichen, wonach in dem Regelverstärker das verstärkte und gleichgerichtete Referenzwiderstands-Ausgangssignal als Ist-Signal mit einem Signal eines Spannungsnormals als Soll-Signal verglichen und als Vergleichsergebnis ein Stellsignal vom Regelverstärker auf einen Steuer-Eingang des Wechselspannungsverstärker gegeben wird. Damit wird errreicht, dass das verstärkte und gleichgerichtete Referenzwiderstands-Ausgangssignal stets auf einem Wert verbleibt, der dem Spannungsnormal gleicht.

In Ausgestaltung der Erfindung weist die Auswerteschaltung einen Gleichspannungsverstärker für das Änderungssignal sowie eine nachgeschaltete Triggerstufe auf. Ferner empfiehlt es sich, den positiv verstärkenden Gleichspannungsverstärker mit dem negativ verstärkenden Inverter in inniger körperlicher Verbindung zu einer integrierten Schaltung zu vereinigen, um eine mögliche Temperaturdrift beider Schaltungen zu kompensieren.

Die Erfindung ist mit besonderem Vorteil im Rahmen eines kapazitiven Sensors verwendbar, welcher eine Veränderung der Dielektrizitätskonstanten zwischen den Platten des Kondensators erfaßt. Mit der Erfindung ist es möglich, das Auftreten eines Stoffes zwischen den Platten des Kondensators sicher zu detektieren, der beispielsweise wie geschäumtes Polystyrol eine Dielektrizitätskonstante εᵣ < 1,1 besitzt. Andererseits kann mit der Erfindung auch ein Material mit einer hohen Dielektrizitätskonstanten wie beispielsweise Wasser mit εᵣ = 81 erfaßt werden.

Ferner kann die Erfindung als hochempfindlicher Annäherungssensor verwendet werden, indem eine der Kondensatorplatten mit Masse verbunden wird. So erlaubt die Erfindung die sichere Erfassung der Änderung von etwa 0,1pF bei einer nahezu beliebig großen Kondensatorkapazität.

Bevorzugte Ausgestaltungen der Erfindung sind in den Unteransprüchen angegeben. Nachfolgend werden Ausführungsbeispiele der Erfindung anhand der beigefügten Zeichnung im einzelnen erläutert. Es zeigen:
- Fig. 1:: eine erste Ausführungsform einer Schaltungsanordnung zur Erfassung von Kapazitätsänderungen;
- Fig. 2:: einen zur Schaltungsanordnung nach Fig. 1 zusätzlichen Regelkreis, und
- Fig. 3:: eine Variante zur Schaltungsanordnung nach Fig. 2.

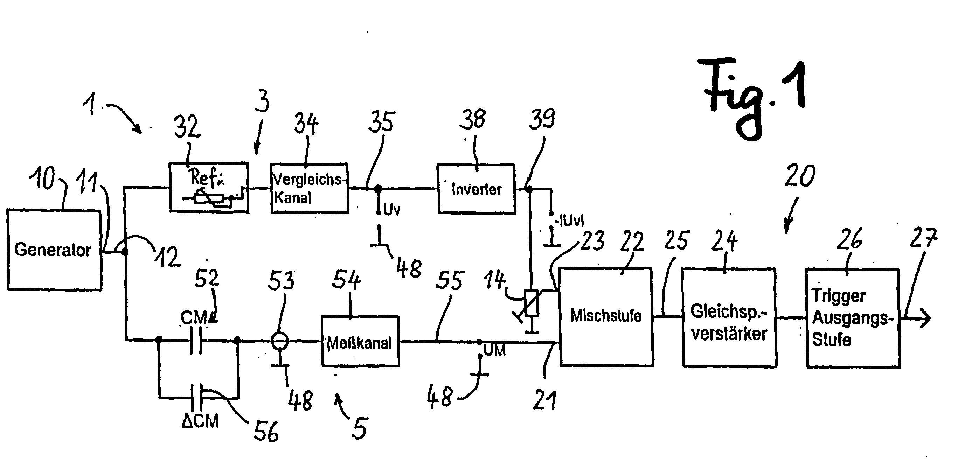

Die Schaltungsanordnung nach Fig. 1 weist eine Art Brückenschaltung auf, die im ganzen mit 1 bezeichnet und aus einem ersten Brückenzweig 5 sowie einem zu diesem parallel geschalteten zweiten Brückenzweig 3 gebildet ist. Eingangsseitig wird die Brückenschaltung von einem Wechselspannungsgenerator 10 in der Weise mit einer Wechselspannung beaufschlagt, dass der Ausgang 11 des Wechselspannungsgenerators 10 einerseits zum ersten Brückenzweig 5 und andererseits zum zweiten Brückenzweig 3 geführt ist.

Im ersten Brückenzweig 5 liegt eine Reihenschaltung aus dem Meßkondensator 52 und einem Meßkanal 54, der seinerseits eine Reihenschaltung aus einem im einzelnen nicht dargestellten Wechselspannungsverstärker und Gleichrichter umfaßt. Das auf der Ausgangsleitung 55 des Meßkanals 54 auftretende, gleichgerichtete Signal gegen Bezugspotential 48 ist mit UM bezeichnet. Die Abschirmung 53 des den Kondensator 52 mit dem Eingang des Meßkanals verbindenden Kabels liegt auf Bezugspotential.

Der Meßkondensator 52 besitzt eine Grundkapazität, die sich aus den geometrischen Verhältnissen der Anordnung ergibt, sowie einen veränderbaren Kapazitätsanteil, der sich aus der zu messenden Veränderung, wie z.B. Material vorhanden bzw. nicht vorhanden, ergibt, und der in der Schaltung als ein dem Meßkondensator 52 parallel geschalteter Kondensator 56 mit veränderlicher Kapazität ΔCM eingetragen ist. Der zweckmäßig niedrige Eingangswiderstand des Meßkanals 54 und der Meßkondensator 52 bilden einen Spannungsteiler.

Der zweite Brückenzweig 3 weist eine Reihenschaltung aus einem veränderbaren Ohm'schen Referenzwiderstand 32, einem diesen nachgeschalteten Vergleichskanal 34 und einem letzteren nachgeschalteten Inverter 38 auf. Der Referenzwiderstand 32 bildet mit dem Eingangswiderstand des Vergleichskanals einen Ohm'schen Spannungsteiler gegen Bezugspotential, dessen Abgriff dem Eingang des Vergleichskanals 34 zugeführt ist. Der Vergleichskanal 34 umfaßt einen nicht dargestellten Wechselspannungsverstärker mit nachgeschaltetem Gleichrichter, so dass auf dessen Ausgangsleitung 35 eine Gleichspannung UV gegen Bezugspotential 48 besteht. Diese Spannung UV wird in dem Inverter 38 invertiert, so dass auf dessen Ausgangsleitung 39 der negative Absolutbetrag der Spannung UV auftritt.

Die Mischstufe 22 enthält im wesentlichen einen im einzelnen nicht dargestellten Summierer, der das Signal UM mit dem am zweiten Eingang 23 anstehenden negativen Signal kombiniert. Am Ausgang 25 der Mischstufe 22 erscheint ein Änderungssignal UD gegenüber Referenzpotential 48 entsprechend der Differenz aus den Signalen bei 21 und 23. Das Brückengleichgewicht wird, wie noch erläutert wird, für den Kapazitätswert 0 des Kondensators 56 (ΔCM) eingestellt, damit sind die Signale UM und UV betragsmäßig gleich. Hat der Kondensator 56 einen endlichen, wenn auch noch so kleinen Widerstand, so ist die Amplitude des Änderungssignals auf Leitung 25 proportional zu diesem Betrag.

Das Änderungssignal am Ausgang 25 wird einer Auswerteschaltung 20 zugeführt, die eine Reihenschaltung aus einem Gleichspannungsverstärker 24 und einer Triggerstufe 26 aufweist. Der Gleichspannungsverstärker 24 verstärkt das Änderungssignal auf Leitung 25 auf einen Wert, der der nachgeschalteten Triggerstufe 26 zugeführt wird. Je genauer die Signale UM und UV betragsmäßig einander durch Abgleich gleich gemacht sind, desto größer kann der Verstärkungsfaktor des Gleichspannungsverstärkers 24 gewählt werden. Zum Abgleich dient ein Potentiometer 14, welches zwischen dem Ausgang 39 und Bezugspotential geschaltet ist und dessen Abgriff am Eingang 23 des Summierers 22 anliegt.

Die Übertragungseigenschaften für das Ausgangssignal des Generators 10 über den ersten Brückenzweig 5 und über den zweiten Brückenzweig 3 müssen gleich sein. Das bedeutet, dass der Referenzwiderstand 32 nicht notwendigerweise dem äquivalenten Widerstandswert des Kondensators 52 entsprechen muß. Bei Abweichungen kann der Vergleichskanal 34 hinsichtlich seiner Verstärkungsfaktors so eingestellt werden, dass die erwähnte Übertragungseigenschaft für das Ausgangssignal des Generators 10 über beide Brückenzweige 5, 3 gleich bleibt. Im übrigen sollten der Vergleichskanal 34 und der Meßkanal 54 identisch sein, was insbesondere für die Temperaturabhängigkeit (Drift) ihrer jeweiligen Ausgangssignale zutreffen soll. Daher empfiehlt es sich, den Vergleichskanal 34 und den Meßkanal 54 zu einer integrierten Schaltung körperlich zusammenzufassen.

Die Mischstufe 22, die zweckmäßig Ohm'scher Natur sein kann, zeigt üblicherweise aufgrund ihres einfachen Aufbaus keine Drift ihres Ausgangssignals. Ein Temperaturgang der Ausgangssignale des Inverters 38 einerseits und des Gleichspannungsverstärkers 24 andererseits ist dagegen zu erwarten. Da der Inverter 38 negativ verstärkt (invertiert) und der Gleichspannungsverstärker 24 andererseits positiv verstärkt, kann die Drift beider Schaltungen zweckmäßig dadurch kompensiert werden, dass der Inverter 38 und der Gleichspannungsverstärker 24 ebenfalls zu einer integrierten Schaltung körperlich verbunden werden.

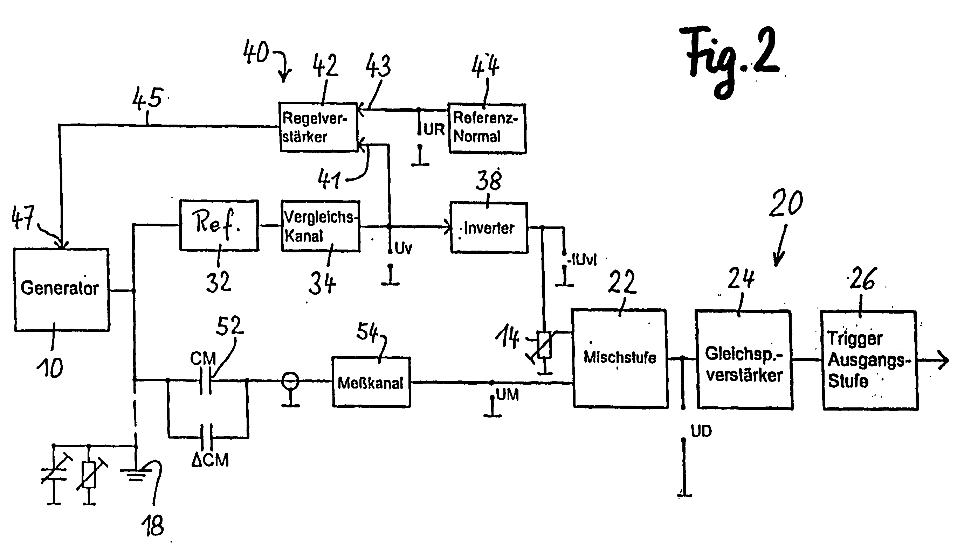

Eine weitere Stabilitätsmaßnahme ist in einer weiteren Ausführungsform der Schaltungsanordnung gemäß Fig. 2 durch einen zusätzlichen Regelkreis 40 für das Ausgangssignal des Generators 10 vorgesehen. Dazu wird das Ausgangssignal UV des Vergleichskanals 34 als Istsignal einem Eingang 41 eines Regelverstärkers 42 zugeführt, dessen anderer Eingang 43 als Sollsignal eine Referenz-Normalspannung UR aus einer Schaltung 44 aufnimmt. Das Stellsignal aus dem Regelverstärker 42 auf Leitung 45 wird einem Steuereingang 47 des Generators 10 zugeführt. Damit führt der Regelkreis 40 das Signal UV stets auf das Signal UR hin. Durch diese Schaltungsausführung können gleichzeitig die Driftgrößen mehrerer Schaltungskomponenten gegenseitig kompensiert werden.

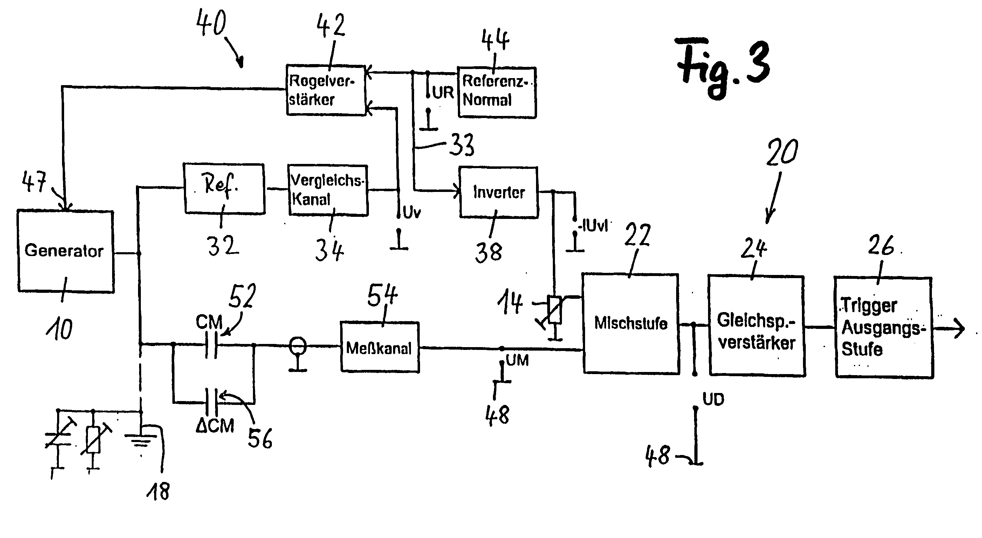

Da im Betrieb der Schaltungsanordnung nach Fig. 2 die Spannung UV stets gleich der Spannung UR ist, ist auch eine Gestaltung der Schaltungsanordnung nach Fig. 3 möglich. Sie unterscheidet sich nur dadurch von der Schaltungsanordnung nach Fig. 2, dass dem Inverter 38 nicht das verstärkte und gleichgerichtete Referenzwiderstands-Ausgangssignal UV sondern die Spannung UR aus der Schaltung 44 über Leitung 33 zugeführt wird, ohne dass sich dadurch an dem beschriebenen grundstäzlichen Betriebsverhalten der Schaltungsanordnung Änderung ergäben, allerdings wird so eine optimale Driftkompensation für die gesamte Schaltungsanordnung erzielt.

Die Erfindung läßt sich als kapazitiver Annäherungsschalter beispielsweise bei der Prüfung auf das Vorhandensein einer Compact Disk (CD) in einer geschlossenen Verpackung verwenden. Die CD-Verpackung liegt auf einer metallischen Rollenbahn auf. Die Rollenbahn sowie alle auf Schutzleiter liegenden Maschinenteile bilden in der erfindungsgemäßen Schaltungsanordnung die mit dem Wechselspannungsgeneratorausgang verbundene Elektrode des Kondensators 52. Die andere Kondensatorelektrode hat die gleiche Form und Abmessung wie die CD selbst und ist bei dem Meßvorgang zur CD-Verpackung im Abstand von beispielsweise 5 mm deckungsgleich positioniert. Die der CD-Verpackung entgegengesetzte Seite der Kondensatorelektrode sowie das Kabel bis zum Eingang des Wechselspannungsverstärkers 54 sind abgeschirmt. Enthält eine CD-Verpackung keine CD, bewirkt dies relativ zu einer CD-Verpackung mit eingeschlossener CD eine Änderung der Dielektrizitätskonstanten und damit eine Kapazitätsänderung am Kondensator 52, die von der erfindungsgemäßen Schaltungsanordnung erfaßt werden kann. Gegenüber einem üblichen kapazitiven Annäherungsschalter mit beispielsweise 30 mm Durchmesser aktiver Elektrodenfläche kann so die Kapazitätsänderung um den Faktor 50 vergrößert werden. Damit wird also auch eine um den Faktor 50 vergrößerte Meßsicherheit erzielt.

Eine weitere Anwendungsmöglichkeit ist die Detektion von Produkten mit sehr niedriger Dielektrizitätskonstante, wie z.B. aufgeschäumte Verpackungsmittel. Durch die extreme Temperaturkonstanz der Schaltungsanordnung einerseits sowie die leichte Anpassungsmöglichkeit an nahezu beliebig große Meßkapazitäten und damit einhergehender Vergrößerung der variablen Kapazität andererseits sind auch solche Produkte absolut sicher meßtechnisch zu erfassen.

Die mit der Generatoreingangsleitung 12 verbundene Elektrode des Kondensators 52 kann mit dem vom internen Bezugspotential 48 verschiedenen Maschinenpotential 18 verbunden bzw. durch dieses selbst gebildet werden.

## Patentansprüche

1. Schaltungsanordnung zum Erfassen von Kapazitätsänderungen eines Kondensators (52, 56), bei der in einem ersten Brückenzweig (5) einer mit einer Wechselspannung beaufschlagten Art von Brückenschaltung der Kondensator (52, 56) und in einem elektrisch parallelen zweiten Brückenzweig (3) ein Referenzwiderstand (32) vorgesehen ist, wobei
in dem ersten Brückenzweig (5) dem Kondensator (52, 56) ein Messkanal (54) und in dem zweiten Brückenzweig (3) dem Referenzwiderstand (32) ein Vergleichskanal (34) nachgeschaltet ist,
die beiden Brückenzweige (3, 5) für das Ausgangssignal eines Wechselspannungsgenerators (10) gleiche Übertragungseigenschaft haben,
das verstärkte und gleichgerichtete, auf einer Ausgangsleitung des Vergleichskanals (34) auftretende Signal (UV) von dem verstärkten und gleichgerichteten, auf einer Ausgangsleitung des Messkanals (54) auftretende Signal (UM) subtrahiert und das sich aus der Subtraktion ergebende Änderungssignal einer Anzeigeschaltung (20) zugeführt wird, **gekennzeichnet, durch** einen Regelkreis (40), der einen Regelverstärker (42) aufweist, der an einem Eingang (41) das verstärkte und gleichgerichtete, auf der Ausgangsleitung des Vergleichskanals auftretende Signal (UV) als Ist-Signal und an einem zweiten Eingang (43) ein Signal eines Spannungsnormals (UR) als Soll-Signal aufnimmt und an seinem Ausgang (45) ein Stellsignal für den Generator (10) liefert.

2. Schaltungsanordnung nach Anspruch 1, **dadurch gekennzeichnet, dass** der Referenzwiderstand (32) ein rein Ohm'scher Widerstand ist.

3. Schaltungsanordnung nach Anspruch 1 oder 2, **dadurch gekennzeichnet, dass** der Widerstandswert des Referenzwiderstandes (32) einstellbar ist.

4. Schaltungsanordnung nach einem der vorstehenden Ansprüche, **dadurch gekennzeichnet, daß** jeder Brückenzweig (3, 5) je einen Wechselspannungsverstärker (54, 34) mit Gleichrichter aufweist, wobei die Wechselspannungsverstärker (54, 34) elektrisch gleichartig sind.

5. Schaltungsanordnung nach Anspruch 4, **dadurch gekennzeichnet, dass** die beiden Wechselspannungsverstärker (54, 34) mit Gleichrichtern als gemeinsamer integrierter Schaltkreis ausgebildet sind.

6. Schaltungsanordnung nach einem der vorstehenden Ansprüche, **dadurch gekennzeichnet, dass** die Subtraktion durch einen Inverter (38) für das verstärkte und gleichgerichtete, auf der Ausgangsleitung des Vergleichskanals auftretende Signal (UV)und einen nachgeschalteten Summenbildner (22) realisiert ist.

7. Schaltungsanordnung nach einem der vorstehenden Ansprüche, **dadurch gekennzeichnet, dass** die Anzeigeschaltung (20) eine Reihenschaltung aus einem Gleichspannungsverstärker (24) für das Änderungssignal und einer Triggerstufe (26) aufweist.

8. Schaltungsanordnung nach Anspruch 7, **dadurch gekennzeichnet, dass** der Gleichspannungsverstärker (24) und der Inverter (38) zu einer integrierten Schaltung vereinigt sind.

9. Schaltungsanordnung nach einem der vorstehenden Ansprüche, **dadurch gekennzeichnet, dass** der Regelkreis (40) zur Stabilisierung des Wechselspannungs-Ausgangssignals des Generators (10) ausgebildet ist.

10. Schaltungsanordnung nach einem der vorstehenden Ansprüche, **dadurch gekennzeichnet, dass** dem Inverter (38) eingangsseitig das Signal des Spannungsnormals (UR) statt des verstärkten und gleichgerichteten, auf der Ausgangsleitung des Vergleichskanals auftretenden Signals (UV)zugeführt ist.

11. Schaltungsanordnung nach einem der vorstehenden Ansprüche, **dadurch gekennzeichnet, dass** eine Abgleicheinrichtung (14) für das verstärkte und gleichgerichtete, auf der Ausgangsleitung des Vergleichskanals auftretende Signal (UV) für dessen Abgleich mit dem verstärkten und gleichgerichteten, auf der Ausgangsleitung des Messkanals auftretenden Signal (UM) vorgesehen ist.

12. Schaltungsanordnung nach Anspruch 11, **dadurch gekennzeichnet, dass** die Abgleicheinrichtung ein Potentiometer (14) aufweist, dessen Abgriff einem zweiten Eingang (23) eines Summen- oder Differenzbildners (22) zugeführt ist, dessen erster Eingang (21) das verstärkte und gleichgerichtete, auf der Ausgangsleitung des Messkanals auftretende Signal (UM) aufnimmt.

13. Verwendung der Schaltungsanordnung nach einem der vorstehenden Ansprüche zur Erfassung von unterschiedliche Dielektrizitätskonstanten aufweisenden Stoffen oder Gegenständen zwischen den Platten des Kondensators.

14. Verwendung der Schaltungsanordnung nach einem der Ansprüche 1 bis 12 als Annäherungssensor.

## Claims

1. Circuit arrangement for detecting changes in the capacitance of a capacitor (52, 56), in which the capacitor (52, 56) is provided in a first bridge branch (5) of a type of bridge circuit that is subject to AC voltage, and a reference resistor (32) is provided in an electrically parallel second bridge branch (3),
wherein in the first bridge branch (5) a measurement channel (54) is placed downstream of the capacitor (52, 56) and in the second bridge branch (3) a comparison channel (34) is placed downstream of the reference resistor (32), the two bridge branches (3, 5) have the same transmission characteristic for the output signal of an AC voltage generator (10),
the amplified and rectified signal (UV) that occurs on an output line of the comparison channel (34) is subtracted from the amplified and rectified signal (UM) that occurs on an output line of the measurement channel (54), and the alteration signal resulting from the subtraction is supplied to a display circuit (20),
**characterised by**
a control circuit (40) that has a control amplifier (42) which at one input (41) picks up, as an actual-value signal, the amplified and rectified signal (UV) that occurs at the output line of the comparison channel, and at a second input (43) picks up, as a reference signal, a signal (UR) of a normal voltage unit, and at its output (45) supplies an adjustment signal for the generator (10).

2. Circuit arrangement according to claim 1, **characterised in that** the reference resistor (32) is a purely ohmic resistor.

3. Circuit arrangement according to claim 1 or 2, **characterised in that** the resistance value of the reference resistor (32) is adjustable.

4. Circuit arrangement according to one of the preceding claims, **characterised in that** each bridge branch (3, 5) respectively has an AC voltage amplifier (54, 34) with rectifier, wherein the AC voltage amplifiers (54, 34) are electrically of the same type.

5. Circuit arrangement according to claim 4, **characterised in that** the two AC voltage amplifiers (54, 34) with rectifiers are designed as a common integrated circuit.

6. Circuit arrangement according to one of the preceding claims, **characterised in that** the subtraction is realised by an inverter (38) for the amplified and rectified signal (UV) that occurs on the output line of the comparison channel and [by] a downstream summation unit (22).

7. Circuit arrangement according to one of the preceding claims, **characterised in that** the display circuit (20) has a series circuit comprising a DC voltage amplifier (24) for the alteration signal and a trigger stage (26).

8. Circuit arrangement according to claim 7, **characterised in that** the DC voltage amplifier (24) and the inverter (38) are united to form an integrated circuit.

9. Circuit arrangement according to one of the preceding claims, **characterised in that** the control circuit (40) is designed to stabilise the AC voltage output signal of the generator (10).

10. Circuit arrangement according to one of the preceding claims, **characterised in that** on the input side, the inverter (38) is supplied with the signal (UR) of the normal voltage unit instead of the amplified and rectified signal (UV) that occurs on the output line of the comparison channel.

11. Circuit arrangement according to one of the preceding claims, **characterised in that** a balancing device (14) is provided for the amplified and rectified signal (UV) that occurs on the output line of the comparison channel, to balance it with the amplified and rectified signal (UM) that occurs at the output line of the measurement channel.

12. Circuit arrangement according to claim 11, **characterised in that** the balancing device has a potentiometer (14) whose tap is supplied to a second input (23) of a summation unit or subtraction unit (22) whose first input (21) picks up the amplified and rectified signal (UM) that occurs on the output line of the measurement channel.

13. Use of the circuit arrangement according to one of the preceding claims for the detection of substances or objects, between the plates of the capacitor, that have different dielectric constants.

14. Use of the circuit arrangement according to one of the claims 1 to 12 as a proximity sensor.

## Revendications

1. Circuit servant à détecter les modifications de capacitance d'un condensateur (52, 56) et dans lequel il est prévu, dans une première branche de pont (5) faisant partie d'une sorte de montage en pont alimenté avec une tension alternative, le condensateur (52, 56) et, dans une deuxième branche de pont (3) électriquement parallèle, une résistance de référence (32),
un canal de mesure (54) étant placé en aval du condensateur (52, 56), dans la première branche de pont (5), et un canal de comparaison (34) étant placé en aval de la résistance de référence (32), dans la deuxième branche de pont (3),
les deux branches de pont (3, 5) destinées au signal de sortie d'un générateur de tension alternative (10) ayant des propriétés de transmission identiques,
le signal amplifié et redressé (UV) produit sur une ligne de sortie du canal de comparaison (34) étant soustrait du signal amplifié et redressé (UM) produit sur une ligne de sortie du canal de mesure (54) et le signal de modification résultant de la soustraction étant amené à un circuit d'affichage (20),
**caractérisé par** un circuit de réglage (40) comportant un amplificateur de réglage (42) qui reçoit, à une entrée (41), en tant que signal effectif, le signal amplifié et redressé (UV) produit sur la ligne de sortie du canal de comparaison et, à une deuxième entrée (43), en tant que signal de consigne, un signal d'un étalon de tension (UR), et qui délivre à sa sortie (45) un signal de réglage destiné au générateur (10).

2. Circuit selon la revendication 1, **caractérisé en ce que** la résistance de référence (32) est une résistance purement ohmique.

3. Circuit selon la revendication 1 ou 2, **caractérisé en ce que** la valeur de résistance de la résistance de référence (32) est réglable.

4. Circuit selon l'une des revendications précédentes, **caractérisé en ce que** chaque branche de pont (3, 5) comporte un amplificateur de tension alternative (54, 34) avec redresseur, les amplificateurs de tension alternative (54, 34) étant électriquement analogues.

5. Circuit selon la revendication 4, **caractérisé en ce que** les deux amplificateurs de tension alternative (54, 34) avec redresseurs sont réalisés sous forme de circuit intégré commun.

6. Circuit selon l'une des revendications précédentes, **caractérisé en ce que** la soustraction est réalisée par un inverseur (38) destiné au signal amplifié et redressé (UV) produit sur la ligne de sortie du canal de comparaison et par un sommateur placé en aval (22).

7. Circuit selon l'une des revendications précédentes, **caractérisé en ce que** le circuit d'affichage (20) comporte un montage en série constitué d'un amplificateur de tension continue (24) destiné au signal de modification et d'un seuil de déclenchement (26).

8. Circuit selon la revendication 7, **caractérisé en ce que** l'amplificateur de tension continue (24) et l'inverseur (38) sont réunis en un circuit intégré.

9. Circuit selon l'une des revendications précédentes, **caractérisé en ce que** le circuit de réglage (40) est réalisé pour stabiliser le signal de sortie à tension alternative du générateur (10).

10. Circuit selon l'une des revendications précédentes, **caractérisé en ce que**, au lieu du signal amplifié et redressé (UV) produit sur la ligne de sortie du canal de comparaison, c'est le signal de l'étalon de tension (UR) qui est amené, côté entrée, à l'inverseur (38).

11. Circuit selon l'une des revendications précédentes, **caractérisé en ce qu'**il est prévu un dispositif d'égalisation (14) destiné au signal amplifié et redressé (UV) produit sur la ligne de sortie du canal de comparaison, et ce, pour égaliser ledit signal avec le signal amplifié et redressé (UM) produit sur la ligne de sortie du canal de mesure.

12. Circuit selon la revendication 11, **caractérisé en ce que** le dispositif d'égalisation comporte un potentiomètre (14) dont le prélèvement est amené à une deuxième entrée (23) d'un sommateur ou soustracteur (22) dont la première entrée (21) reçoit le signal amplifié et redressé (UM) produit sur la ligne de sortie du canal de mesure.

13. Utilisation du circuit selon l'une des revendications précédentes pour détecter, entre les plaques du condensateur, des matières ou des objets ayant diverses constantes diélectriques.

14. Utilisation du circuit selon l'une des revendications 1 à 12 en tant que capteur d'approche.
